# EUROPÄISCHE PATENTANMELDUNG

(11) **EP 0 593 846 A2**
(43) Veröffentlichungstag der Anmeldung: **27.04.1994**
(21) Anmeldenummer: 93106417.4
(22) Anmeldetag: 21.04.1993
(51) Int. Cl.: H05K 5/06, H02G 3/08

(54) **Abgedichtetes Gehäuse**

(30) Priorität: 17.10.1992 DE 4235016
(71) Anmelder: KLASCHKA GMBH & CO., D-75233 Tiefenbronn-Lehningen (DE)
(72) Erfinder: Klaschka, Walter, W-7533 Tiefenbronn-Lehningen (DE); Pflüger, Harald, W-7031 Aidlingen (DE); Kiessling, Albert, W-7252 Weil an der Stadt 4 (DE)
(74) Vertreter: Ostertag, Reinhard

(57) **Zusammenfassung**

Um eine große Anzahl von Fühlerkabeln an eine dezentrale Steuereinheit anschließen zu können und eine hermetische Kapselung der Steuereinheit zu gewährleisten, wird ein zweiteiliges Gehäuse (10, 12) vorgeschlagen, bei dem zwischen Rändern des Gehäuses eine aus elastischem Material gefertigte Lochplatte (22) eingeklemmt ist. Diese hat im unbelasteten Zustand größere Abmessung als das sie aufnehmende Fenster (20) des Gehäuses, so daß beim Schließen des Gehäuses die Lochplatte (22) gestaucht wird und die in den Durchführöffnungen (32) befindlichen Fühlerkabel in festen und dichten Reibschluß zur Wand der Durchführöffnungen (32) kommen.

## Beschreibung

Die Erfindung betrifft ein Gehäuse für eine Steuereinheit gemäß dem Oberbegriff des Anspruches 1.

Derartige Gehäuse finden in Verbindung mit dezentralen Steuereinheiten Verwendung, die über einen Feldbus mit einer zentralen Hauptsteuerung verbunden sind und über eine Vielzahl von Kabeln mit Fühlern verbunden sind, die mit der lokal zu steuernden Einrichtung zusammenarbeiten.

Für das Zusammenwirken derartiger Steuereinheiten mit der Hauptsteuerung ergeben sich in der Praxis zwei unterschiedliche Ausprägungen: Eine besteht darin, daß die lokale Steuereinheit lediglich ausgelagerte binäre und analoge Ein-/Ausgabe-Anschlußpunkte enthält, ohne selbst eine logische Verknüpfung oder eine sonstwie geartete Verarbeitung der Ein-/Ausgabesignale durchzuführen. Die zweite Ausprägung besteht aus einer lokalen Programmsteuerung mit binären und analogen Ein/Ausgabe-Anschlußpunkten, die selbständig logische Verknüpfungen oder sonstwie geartete Verarbeitungsfunktionen vornimmt, ohne die Hauptsteuerung zu belasten.

Lokale Steuereinheiten haben auch den Vorteil, daß Kabel nicht über lange Strecken im Fabrikgebäude verlegt werden müssen. Andererseits sind derartige lokale Steuereinheiten schlechteren Umgebungsbedingungen ausgesetzt, müssen insbesondere gegen Staub und Strahlwasser geschützt sein (Schutznorm IP 65).

Bei bekannten solchen Gehäusen für Steuereinheiten, die den genannten Anforderungen entsprechen, ist für jede Kabeldurchführung eine PG-Verschraubung vorgesehen. Derartige Verschraubungen sind nicht nur teuer, sie benötigen auch viel Platz, so daß auf einer gegebenen Fläche des Gehäuses nur wenige Anschlüsse untergebracht werden können.

Durch die vorliegende Erfindung soll ein Gehäuse gemäß dem Oberbegriff des Anspruches 1 so weitergebildet werden, daß eine große Anzahl von Kabeldurchführungen auf kleiner Fläche angeordnet werden kann, trotzdem aber die Dichtheit der Kabeldurchführung, insbesondere auch gegen Strahlwasser, gewährleistet ist.

Diese Aufgabe ist erfindungsgemäß gelöst durch ein Gehäuse gemäß Anspruch 1.

Bei dem erfindungsgemäßen Gehäuse hat man keine radial groß bauenden Verschraubungen, vielmehr ist jedes der Löcher einer Lochplatte mit elastisch verformbaren Dichtmitteln versehen, die sich dicht an die Außenfläche eines dort eingezogenen Kabels anlegen.

Vorteilhafte Weiterbildungen der Erfindung sind in Unteransprüchen angegeben.

Die Weiterbildung der Erfindung gemäß Anspruch 2 ist im Hinblick auf eine besonders dichte Packung der Durchführöffnungen der Lochplatte von Vorteil.

Mit der Weiterbildung der Erfindung gemäß Anspruch 3 wird ein sicheres Halten und Positionieren der Lochplatte erhalten.

Bei Ausbildung der Lochplatte gemäß Anspruch 4 erhält man ein zusätzliches elastisches Einspannen der eingesetzten Kabel automatisch beim Schließen des Gehäuses.

Bei einem Gehäuse gemäß Anspruch 5 ist gewährleistet, daß man auch auf die innenliegenden Abschnitte der Durchführöffnungen zwangsweise eine Kraft beim Schließen der Gehäuseteile erhält.

Bei der im Anspruch 6 angegebenen Ausbildung der Klemmkörper hat man zugleich auch eine Klemmkraft auf die Durchführöffnungen in zur Schließrichtung senkrechter Richtung.

Bei einem Gehäuse gemäß Anspruch 7 ist die Lochplatte in dem einen Gehäuseteil unverlierbar positioniert und zugleich sicher und dicht mit diesem Gehäuseteil verbunden. Eine Dichtstelle mit dem zweiten Gehäuseteil ergibt sich beim Schließen des Gehäuses.

Bei einem Gehäuse gemäß Anspruch 8 kann man beliebige der Durchführöffnungen unbelegt lassen, ohne die Dichtheit des Gehäuses in Frage zu stellen.

Bildet man die Dichtmittel, die bei jeder Durchführöffnung vorgesehen sind, gemäß Anspruch 9 aus, so kann man ein Kabel in Richtung zur Spitze des Kegelstumpfes leicht einziehen und ferner auch Kabel einführen, deren Durchmesser unterschiedlich ist.

Mit der Weiterbildung der Erfindung gemäß Anspruch 10 wird erreicht, daß zusätzlich eine gute Zugentlastung bei Verwendung einer kegelstumpfförmigen Lippendichtung gewährleistet ist, wobei die Montage von Untereinheiten, die jeweils ein Zugentlastungsteil und eine Lippendichtung umfassen, an der Lochplatte sehr einfach ist.

Mit der Weiterbildung der Erfindung gemäß Anspruch 11 wird erreicht, daß der Einknöpfabschnitt der Lippendichtung zugleich als Feder für die Rastverbindung zwischen Zugentlastungsteil und Lochplatte dient.

Bildet man die die Kabelaußenseite abdichtende Lippendichtung gemäß Anspruch 12 aus, so kann sie mit einem einfache Geometrie aufweisenden Formwerkzeug hergestellt werden und aus verhältnismäßig weichem Material bestehen.

Gemäß Anspruch 13 erhält man bei einer solchen Lippendichtung eine axiale Abstützung der Bodenwand bei Schubbelastungen und eine radiale Begrenzung der Verschiebbarkeit des Kabels.

Die Weiterbildung der Erfindung gemäß Anspruch 14 gestattet ein sicheres und dichtes Hindurchführen einer großen Anzahl von Kabeln unterschiedlichen Durchmessers, da man für die verschiedenen Durchführpunkte der starren Lochplatte unterschiedliche elastische Dichtkörper wählen kann, wie dies im Einzelfall benötigt wird. Nicht belegte Öffnungen der Lochplatte können jeweils durch Blindstopfen verschlossen werden.

Bei einem Gehäuse gemäß Anspruch 15 kann man nach Anheben oder vollständigem Entfernen eines oberen Gehäuseteiles die Lochplatten um ihren unteren Rand verschwenken, was im Hinblick auf einfaches Montieren und Anschließen der Kabel und auch im Hinblick auf einfache visuelle Kontrolle der Verkabelung von Vorteil ist.

Bei einem Gehäuse gemäß Anspruch 16 ist zusätzlich gewährleistet, daß die Lochplatten an ihrem einen Längsrand unverlierbar mit dem zugehörigen Gehäuseteil verbunden sind.

Die Weiterbildung der Erfindung gemäß Anspruch 17 erleichtert das Einführen des umlaufenden elastischen Dichtkörpers, der zugleich das eine Teil eines Pfannengelenkes bildet, in die das andere Pfannengelenkteil bildende Nut des zugehörigen Gehäuseteiles.

Die Weiterbildung der Erfindung gemäß Anspruch 18 ist im Hinblick auf ein preiswertes Herstellen des Gehäuses auch in kleinen Serien von Vorteil. Man benötigt nur ein gehäusespezifisches Profilmaterial.

Ein Gehäuse, wie es im Anspruch 19 angegeben ist, ist gut zur Befestigung auf Unterlagen ohne Öffnen des Gehäuses geeignet.

Mit der Weiterbildung der Erfindung gemäß Anspruch 20 wird erreicht, daß sich im Gehäuseinneren auf einfache Weise Platinen oder sonstige plattenförmige Einsatzteile anbringen lassen.

Die Weiterbildung der Erfindung gemäß Anspruch 21 ist im Hinblick auf ein einfaches Anschließen der Kabel von Vorteil.

Bei einem Gehäuse gemäß Anspruch 22 hat man auf dem durch das Fenster sichtbaren plattenförmigen Einsatz Flächen zur Verfügung, auf denen Informationen gut lesbar angebracht werden können, während man zugleich auf der lokalen Steuereinheit vorgesehene Anzeigen beobachten kann.

Die Weiterbildung der Erfindung gemäß Anspruch 23 ist im Hinblick auf eine gute Andichtung zwischen dem Rand der Lochplatten und Dichtstreifen von Vorteil, die zwischen den Gehäuseteilen vorgesehen siond.

Mit der Weiterbildung der Erfindung gemäß Anspruch 24 ist gewährleistet, daß die zwischen den Schließflanschen der Gehäuseteile vorgesehenen Dichtstreifen beim Verschrauben der Gehäuseteile nicht übermäßig auf Kompression beansprucht werden.

Bei einem Gehäuse gemäß Anspruch 25 bleiben die Lochplatten auch nach Lösen des abnehmbaren Gehäuseteiles noch in ihrer Arbeitsstellung, auch dann, wenn die durch sie hindurchgeführten Kabel auf Zug oder Druck belastet sind. Die Verriegelungseinrichtung läßt sich aber im Bedarfsfalle leicht lösen, um die Lochplatte verschwenken oder entnehmen zu können und so besseren Zugang zu den Kabelenden oder dem Gehäuseinneren zu geben.

Nachstehend wird die Erfindung anhand von Ausführbeispielen unter Bezugnahme auf die Zeichnung näher erläutert. In dieser zeigen:
- Figur 1:: eine Aufsicht auf eine Fühler-Anschlußseite eines Gehäuses einer lokalen Steuereinheit;
- Figur 2:: eine Ansicht der rechten Stirnseite des in Figur 1 gezeigten Gehäuses;
- Figur 3:: einen Schnitt durch eine Durchführöffnung einer Lochplatte des Gehäuses nach den Figuren 1 und 2 in vergrößertem Maßstabe;
- Figur 4:: eine ähnliche Ansicht wie Figur 3, in welcher eine abgewandelte Geometrie der Durchführöffnung wiedergegeben ist und zugleich ein über ein Adapterteil eingesetztes dünnes Fühlerkabel wiedergegeben ist;
- Figur 5:: einen transversalen Schnitt durch ein abgewandeltes Gehäuse für eine lokale Steuereinheit;
- Figur 6:: einen Längsschnitt durch eine abgewandelte Lochplatte zur Verwendung in einem Gehäuse nach Figur 1 oder 5;
- Figur 7:: einen transversalen Schnitt durch eine abgewandelte Lochplatte;
- Figur 8:: einen axialen Schnitt durch eine abgewandelte Zugentlastungs/Dichteinheit zur Verwendung an einer Lochplatte;
- Figur 9:: einen transversalen Schnitt durch ein abgewandeltes Gehäuse für eine lokale Steuereinheit;
- Figur 10:: einen vertikalen longitudinalen Teilschnitt durch das Gehäuse nach Figur 9 im Bereich einer Dichtstelle zwischen oberem und unterem Gehäuseteil;
- Figur 11:: eine Aufsicht auf einen Dichtstreifen, der im in Figur 10 gezeigten Dichtbereich verwendet ist; und
- Figur 12:: eine Aufsicht auf eine Informationsplatine, die in das obere Gehäuseteil des Gehäuses nach Figur 10 eingesetzt ist.

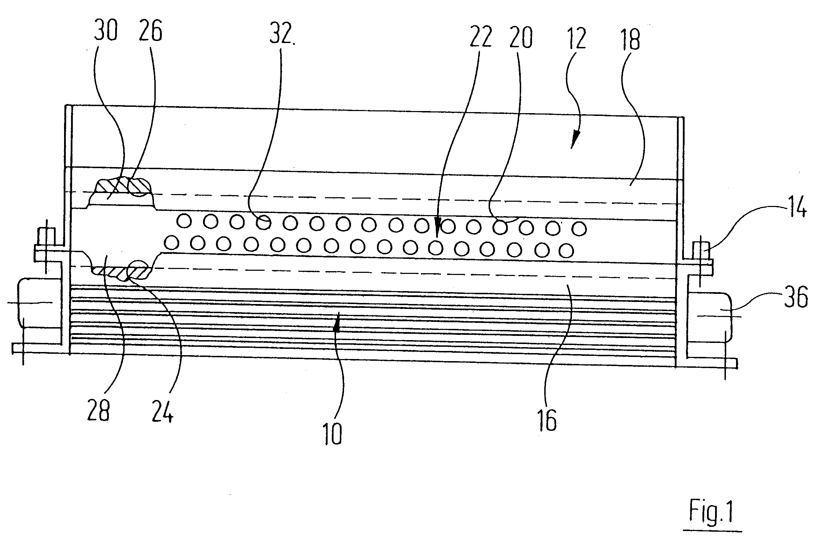

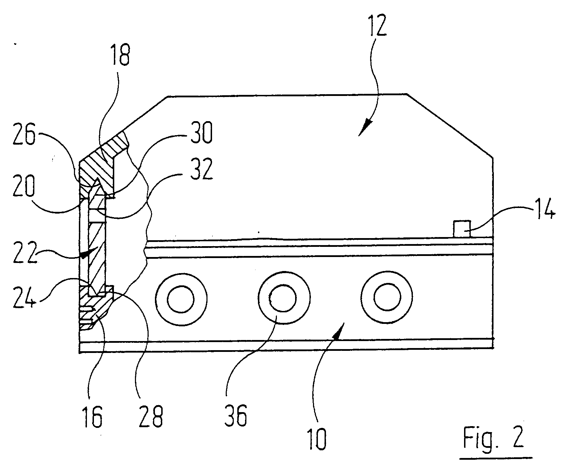

Das in den Figuren 1 und 2 gezeigte Gehäuse für eine dezentrale Steuereinheit hat ein unteres Gehäuseteil 10 und ein oberes Gehäuseteil 12, die jeweils aus einem Strangpressprofil und über nicht wiedergegebene Dichtungen aufgesetzten Stirnplatten bestehen. Die beiden Gehäuseteile 10, 12 haben in der Stoßebene Flansche und sind durch Schrauben 14 miteinander verbunden.

Eine in der Zeichenebene von Figur 1 liegende vordere Wand 16 des unteren Gehäuseteiles 10 und eine darüberliegende vordere Wand 18 des oberen Gehäuseteiles 12 begrenzen zusammen ein Anschlußfenster 20, in welches eine Lochplatte 22 dicht eingesetzt ist. Hierzu ist die Unterseite der Vorderwand 16 mit einer Rechteck-Nut 24 und die Oberseite der Vorderwand 18 mit einer dreieckigen Querschnitt aufweisenden Nut 26 versehen. Die Lochplatte 22 hat einen unteren formschlüssig in die Nut 24 passenden Randabschnitt 28 und einen oberen dreieckigen Querschnitt aufweisenden Randabschnitt 30, der formschlüssig in die Nut 26 passt.

Ferner hat die Lochplatte 22 eine Vielzahl von Durchführöffnungen 32, die in zwei Reihen übereinander um eine halbe Teilung versetzt angeordnet sind.

Die Lochplatte 22 ist aus Gummi hergestellt und hat im unverformten Zustand eine etwas größere Höhe als dem Abstand zwischen den Böden der Nuten 24 und 26 bei geschlossenen Gehäuseteilen 10, 12 entspricht. Damit sitzt die Lochplatte 22 bei geschlossenem Gehäuse unter elastischer Vorspannung zwischen den beiden Gehäuseteilen 10, 12, und entsprechend werden die Durchführöffnungen 32 geringfügig verformt. Die Härte des Gummimateriales ist so gewählt, daß man einerseits eine zum Festklemmen von Kabeln ausreichende Verformung der Durchführöffnungen 32 erhält, andererseits die Lochplatte 22 nicht ausflext.

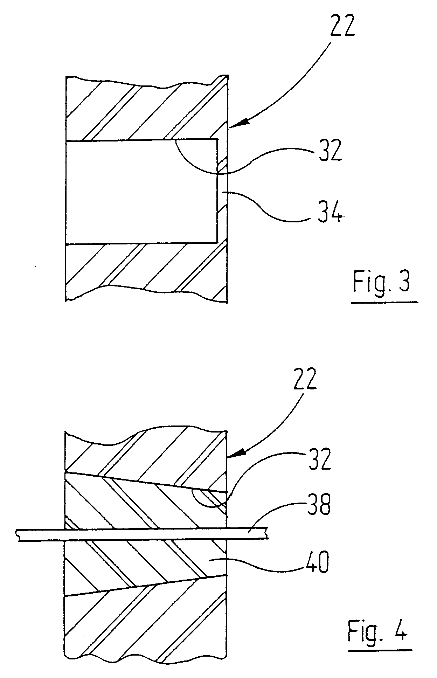

Wie aus Figur 3 ersichtlich, sind die Durchführöffnungen 32 in einer neuen Lochplatte zunächst noch durch einen dünnen Film 34 verschlossen, der mit einer Ahle oder einem Dorn leicht aufgebrochen werden kann, um ein Kabel einzuführen, durch welches eine im Inneren des Gehäuses untergebrachte Steuerung mit einem Fühler verbunden wird.

Bei dem in Figur 1 und 2 gezeigten Gehäuse werden zum Anschluß der verschiedenen Fühler Kabel gleichen Durchmessers verwendet, die bei unbelasteter Lochplatte 22 gerade noch unter Reibung durch eine Durchführöffnung 32 gezogen werden können. Ist die Lochplatte 22 dann nach Schließen des Gehäuses unter Vorspannung, so sitzen die eingezogenen Kabel unverrückbar in der zugeordneten Durchführöffnung, so daß man gleichzeitig eine sichere Abdichtung und eine Zugentlastung des Kabels erhält.

Man erkennt, daß man auf die oben beschriebene Weise eine sehr große Anzahl von Kabeln einfach, zuverlässig und dicht auf kleiner Fläche in ein Gehäuse einführen kann.

In Figur 1 und 2 sind zusätzlich auf den Stirnseiten des Gehäuseteiles 10 als PG-Verschraubungen ausgeführte Kabeldurchführungen 36 wiedergegeben, die zum Anschluß von eine große Anzahl von Adern aufweisenden Datenkabeln (gegebenenfalls auch über Steckverbindungen) dienen. Diese Anschlüsse, die nur in geringer Zahl vorgesehen zu werden brauchen, können auf den Stirnflächen des Gehäuseteiles 10 Platz finden.

Sind für bestimmte Einsätze an ein und demselben Gehäuse Kabel unterschiedlichen Durchmessers durchzuführen, kann man die Lochplatte 22 auch in unterschiedlichen Abschnitten mit Durchführöffnungen 32 unterschiedlicher Größe versehen, wobei man für sehr große Kabel in diesen Bereichen auch nur eine einzige Reihe von Durchführöffnungen haben kann.

Es versteht sich, daß man die in Figur 1 hinten liegende Wand des Gehäuses gleichermaßen mit einer Lochplatte versehen kann, so daß man auf beiden Gehäuseseiten eine sehr große Anzahl von Kabeldurchführungen zur Verfügung hat.

Bei dem abgewandelten Ausführbeispiel nach Figur 4 haben die Durchführöffnungen 32 eine kegelige Umfangswand, wobei die Basisfläche des Kegels auf der Gehäuseinnenseite liegt. Zum dichten und festen Einsetzen eines nur kleinen Durchmesser aufweisenden Kabels 38 ist auf letzteres ein Adapterstück 40 im Reibschluß aufgezogen, dessen Außenfläche zur Durchführöffnung 32 passende Konizität aufweist. Das Material, aus welchem das Adapterstück 40 hergestellt ist, ist vorzugsweise das gleiche Material, aus welchem auch die Lochplatte 22 besteht.

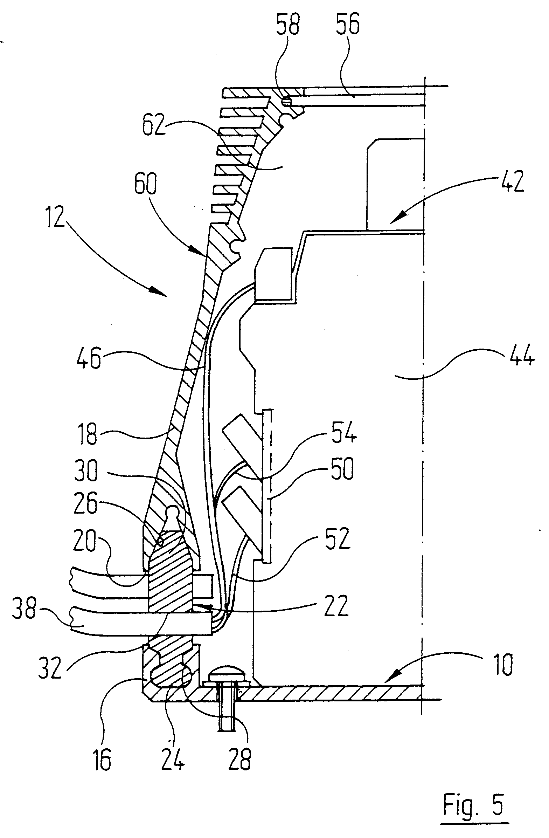

Beim Ausführbeispiel nach Figur 5 sind Teile, die oben schon beschriebenen Teilen funktionell entsprechen, wieder mit denselben Bezugszeichen versehen.

Die untere Nut 24 ist nun schwalbenschwanzförmig ausgebildet und arbeitet mit dem hierzu komplementären unteren Randabschnitt 28 der Lochplatte 22 zusammen. Die Ausbildung der oberen Nut 26 und des oberen Randabschnittes 30 entspricht im wesentlichen Figur 1 und 2 mit dem einzigen Unterschied, daß die Spitze des Randabschnittes 30 abgeplattet ist.

Im Inneren des nur zur Hälfte wiedergegebenen Gehäuses ist eine Steuereinheit 42 wiedergegeben, die ihrerseits ein aus Strangpreßprofilen zusammengebautes Gehäuse 44 aufweist. Letzteres trägt im oberen Bereich eine Steckerleiste, an welche Signalleitungen 46 der mit 38 bezeichneten Fühlerkabel angeschlossen sind. Eine Seitenfläche des Gehäuses 44 trägt eine Montageplatte 50 mit Steckerleisten für die Fühler-Versorgungsspannungen, an welche Versorgungsleitungen 52, 54 der Fühlerkabel 38 angeschlossen sind. Wie aus Figur 5 ersichtlich, ist die Oberseite des Gehäuses durch eine transparente Deckplatte 56 verschlossen, die unter Zwischenschaltung einer Dichtung 58 in eine Nut am oberen Ende zweier Strangpreßprofilteile 60 eingreift, die zusammen mit Stirnplatten 62 das obere Gehäuseteil 12 bilden.

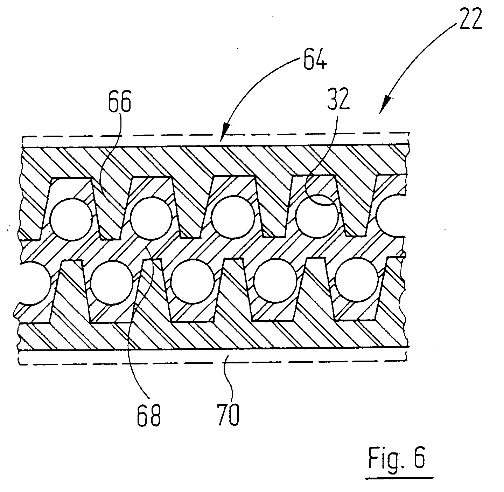

Die in Figur 6 wiedergegebene abgewandelte Lochplatte 22 umfaßt zwei kammähnliche aus hartem Gummi gefertigte Klemmkörper 64, deren Zinken 66 um eine halbe Teilung gegeneinander versetzt sind, wobei die seitlichen Flanken der Zinken zur Spitze hin aufeinander zulaufen.

Der Zwischenraum zwischen den Klemmkörpern 64 ist mit demgegenüber weichen Gummimaterial 68 ausgebildet, wobei in den zwischen den Zinken 66 liegenden Abschnitten die Durchführöffnungen 32 ausgebildet sind.

Preßt man die Klemmkörper 64 in zu ihrer Längsrichtung senkrechter Richtung gegeneinander, so wird sowohl auf den aussenliegenden Abschnitt als auch auf den innenliegenden Abschnitt einer Durchführöffnung 32 eine in Figur 6 vertikale Kraft ausgeübt. Zugleich verhindern die Zinken 66 ein Ausweichen der seitlichen Wandabschnitte der Durchführöffnungen 32, erzeugen hier auf Grund ihrer Abschrägung sogar noch eine kleine zusätzliche radial nach innen gerichtete Klemmkraft.

Falls gewünscht, kann man die Außenseiten der Klemmkörper 64 nochmals mit einer Schicht 70 aus dem weichen Gummimaterial überziehen, um die Abdichtung zwischen den Randabschnitten 28, 30 und den Nuten 24, 26 zu verbessern.

In weiterer Abwandlung der Erfindung kann man den Durchführöffnungen 32 auch geringfügig ovale Gestalt geben, wobei die lange Achse des Ovals in Schließrichtung der Gehäuseteile, also senkrecht zur Längsrichtung der Lochplatte 22 verläuft. Eine derartige Ausbildung der Durchführöffnung erleichtert ein Einziehen des Kabels, wobei aber durch die beim Einspannen der Lochplatte 22 erhaltene Verformung in Schließrichtung gewährleistet ist, daß auch die zunächst etwas von der Kabeloberfläche abgehobenen oberen und unteren Randabschnitte der Durchführöffnung in satte Anlage an die Kabeloberfläche kommen.

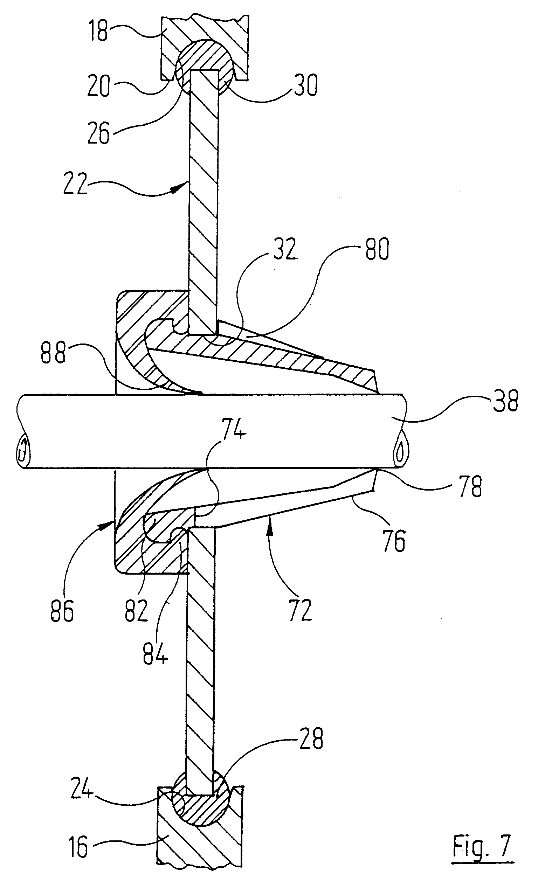

Die abgewandelte Lochplatte 22 nach Figur 7 ist ein Blechteil, aus welchem die Durchführöffnungen 32 ausgestanzt sind. Die elastisch verformbaren Randabschnitte 28, 30 sind durch auf die Plattenränder aufgesetzte oder aufvulkanisierte Profile gebildet.

Bei jeder der Durchführöffnungen 32 ist ein aus hartem elastischem Kunststoff gespritzter Klemmkörper 72 eingesetzt, der im wesentlichen kegelstumpfförmig ausgebildet ist. Durch Schlitze 74 beim kleinen Ende des Klemmkörpers 72 erhält man einzelne Klemmarme 76, die mit schneidenförmigen Enden an der Außenfläche eines Fühlerkabels 48 angreifen. Auf der Außenseite der Klemmarme 76 sind Schnappnasen 80 angeformt, deren Hinterkante mit der Innenfläche der Lochplatte 22 zusammenarbeitet.

Bei ihrer Basisfläche haben die Klemmkörper 72 einen radial nach außen überstehenden Wulst 82, dessen rechtsgelegene Ringfläche unter Abstand vor der Außenfläche der Lochplatte 22 endet. In diesem Zwischenraum ist ein Einknöpfwulst 84 eines insgesamt mit 86 bezeichneten Dichtkörpers unter Kompression eingespannt. Der Dichtkörper hat eine im wesentlichen kegelstumpfförmige Dichtlippe 88, die mit zur Innenseite der Lochplatte weisender Spitze ausgebildet ist. Die freie Randkante der Dichtlippe 88 greift unter elastischer Verformung an der Außenfläche des Fühlerkabels 38 an.

Das Montieren einer Kabeldurchführung nach Figur 7 läßt sich wie folgt durchführen:

Zunächst wird der Dichtkörper 86 mit seinem Einknöpfwulst 84 auf dem Klemmkörper 72 befestigt. Dann wird der Klemmkörper 72 von außen durch die für ihn vorgesehene Durchführöffnung 32 geschoben. Anschließend wird das Fühlerkabel 38 in der Zeichnung von links nach rechts durch die Dichtlippe 88 und die Klemmarme 76 geschoben. Mit diesem Einschieben erhält man automatisch die Abdichtung und die Zugentlastung an der Kabeldurchführung.

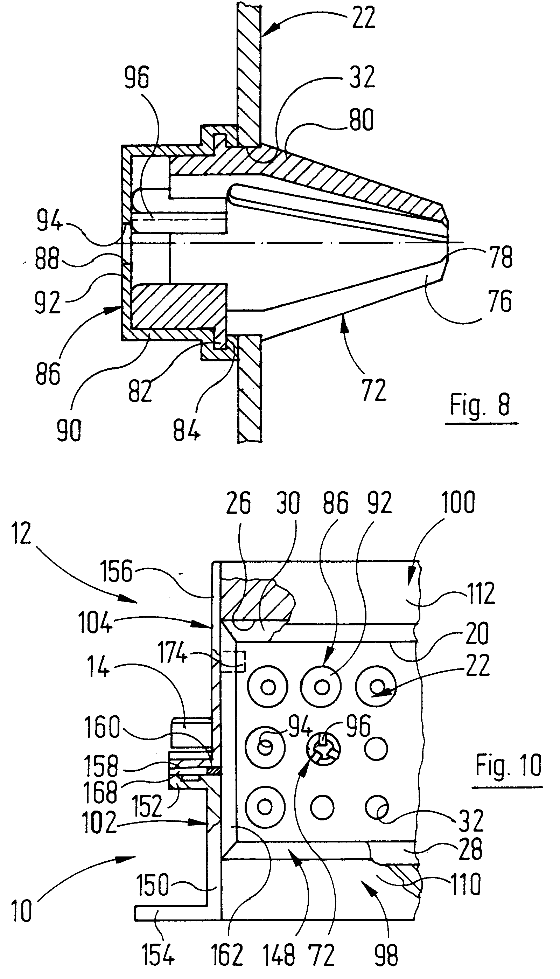

Die in Figur 8 gezeigte Zugentlastung/Dichteinheit für ein durch eine Lochplatte durchgeführtes Kabel hat im wesentlichen denselben Aufbau wie in Figur 7 gezeigt. Entsprechende Komponenten der Einheit sind wieder mit denselben Bezugszeichen versehen.

Beim Ausführungsbeispiel nach Figur 8 hat der Dichtkörper 86 die Form eines Becherteiles mit einer zylindrischen Umfangswand 90 und einer ebenen Bodenwand 92 mit einer mittigen Durchführöffnung 94, deren Durchmesser kleiner ist als der des kleinsten zusammen mit diesem Dichtkörper zu verwendenden Kabels. Die Bodenwand 92 ist durch die axialen Stirnflächen von 3 in Umfangsrichtung gleich verteilten Positionierrippen 96 abgestützt, deren radial innenliegende Flächen zugleich ein seitliches Auswandern eines durch die Einheit hindurchgezogenen Kabels verhindern. Bei eingezogenem Kabel legt sich der radial innerste Abschnitt der ringförmigen Bodenwand 92 über die abgerundete innere Kante der Positionierrippen 96 und nimmt im wesentlichen kegelstumpfförmige Gestalt an, wobei der innere Rand der Durchführöffnung 94 satt auf der Außenfläche des Mantels des durchgeführten Kabels sitzt. Auf Grund dieser Konstruktion kann der in Figur 8 gezeigte Dichtkörper aus verhältnismäßig weichem Material gefertigt werden, ohne die Dichtheit der Kabeldurchführung zu beeinträchtigen.

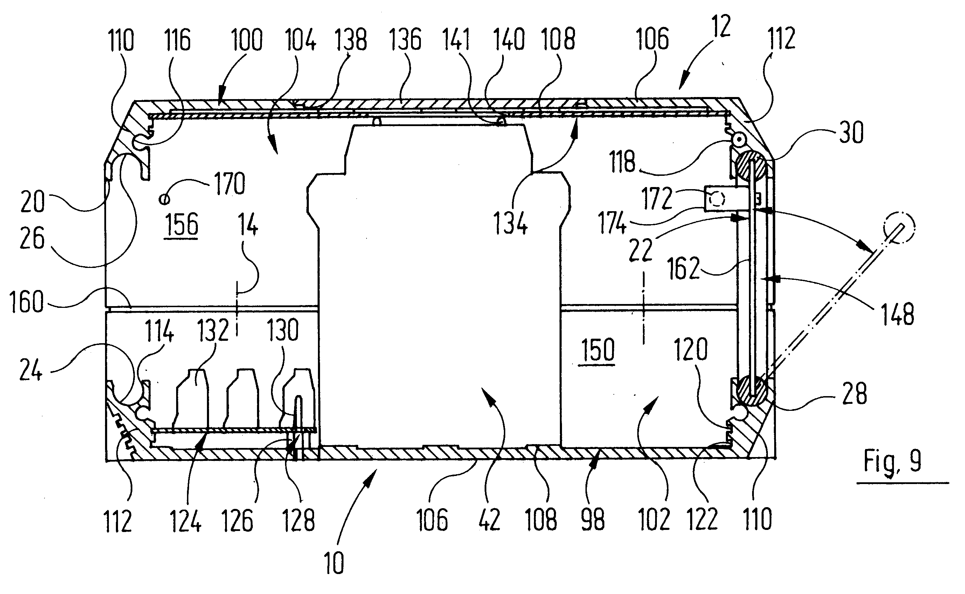

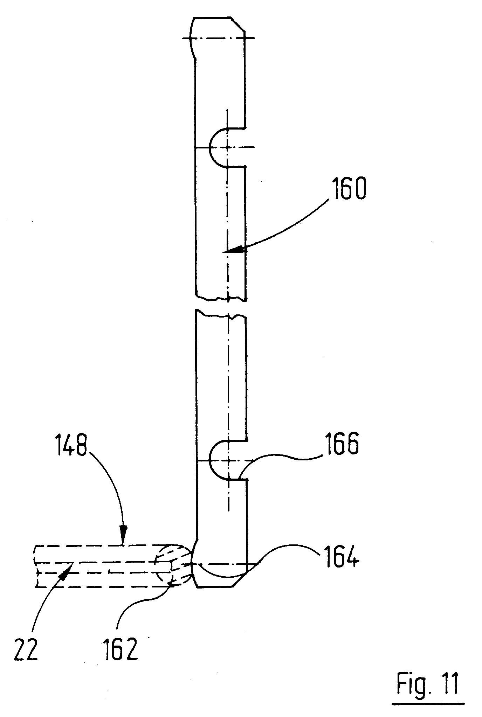

Bei dem abgewandelten Gehäuse nach den Figuren 9 und 10 sind Gehäuseteile, die von der Funktion her schon unter Bezugnahme auf die Figuren 1 und 2 erläuterten Gehäuseteilen entsprechen, wieder mit denselben Bezugszeichen versehen. Diese Gehäuseteile werden nachstehend nicht nochmals detailliert beschrieben. Das Gehäuse ist, soweit nicht nachstehend explizit anders angegeben, symmetrisch zu einer horizontalen Mittelebene und symmetrisch zu einer vertikalen Mittelebene. Teilweise sind in Bereichen des Gehäuses Komponenten der besseren Übersichtlichkeit halber nicht wiedergegeben, die in einem anderen symmetrisch äquivalenten Bereich gezeigt sind. Diese Komponenten sind jeweils symmetrisch ergänzt als auch in den anderen Bereichen vorhanden zu denken.

Das untere Gehäuseteil 10 und das obere Gehäuseteil 12 bestehen aus im wesentlichen identischen Grundteilen 98, 100, die durch Ablängen von einem gehäusespezifischen extrudierten Profilmaterial erhalten wurden, sowie aus Seitenteilen 102, 104, die durch Ablängen von Standard-Winkelprofilmaterialien hergestellt sind.

Das kundenspezifische extrudierte Aluminiumprofil ist im Grundteil 98 unverändert erhalten. Es hat eine Bodenwand 106 mit drei geringfügig vorstehenden Auflagerippen 108 rechteckigen Querschnitts, auf welchen das Gehäuse 44 der Programmsteuerung 42 sitzt. An die Ränder der Bodenwand 106 sind Randwände 110, 112 angeformt, in deren Oberseite die Nuten 24 (bzw. 26) eingeformt sind. Diese haben über einen Winkel von etwa 225^{o} kreisförmigen transversalen Querschnitt. Beim freien Rand der Nuten sind unter 30^{o} zur Vertikalen geneigte Einführschrägen 114 vorgesehen.

Auf der Innenseite der Randwände 110, 112 sind Schraubenkanäle 116 eingeformt, die selbstschneidende Schrauben 118 aufnehmen, über welche die Seitenteile 102, 104 am jeweiligen Grundteil 98 bzw. 100 befestigt werden.

Beabstandete Tragnuten 120, 122 dienen zur Aufnahme von Rändern von plattenförmigen Einsatzteilen.

Im unteren Gehäuseteil 10 sind als derartige plattenförmige Einsatzteile Anschlußplatinen 124 vorgesehen, die mit ihrem außenliegenden Rand in eine Tragnut 120 eingreifen und auf der Unterseite ihres inneren Randes Distanzkörper 126 tragen, die auf der Oberseite der Bodenwand 106 aufsitzen. In die Bodenwand 116 sind Verriegelungszapfen 128 eingesetzt, die eine durch eine Öffnung der Anschlußplatine hindurchgeführte federnde Rastnase 130 aufweisen. Die Oberseite der Anschlußplatinen 124 trägt verschiedene Klemmleisten 132, an denen die Leiter der anzuschließenden Kabel befestigt werden.

Im oberen Gehäuseteil 12 ist eine sich quer über die gesamte Bodenwand erstreckende Informationsplatine 134 mit ihren Längsrändern in die Tragnuten 122 eingesetzt. Deren Oberseite ist durch ein transparentes Fenster 136 sichtbar, welches in eine Öffnung 138 dicht eingeklebt ist, die in der Bodenwand des oberen Gehäuseteiles 12 ausgefräst ist.

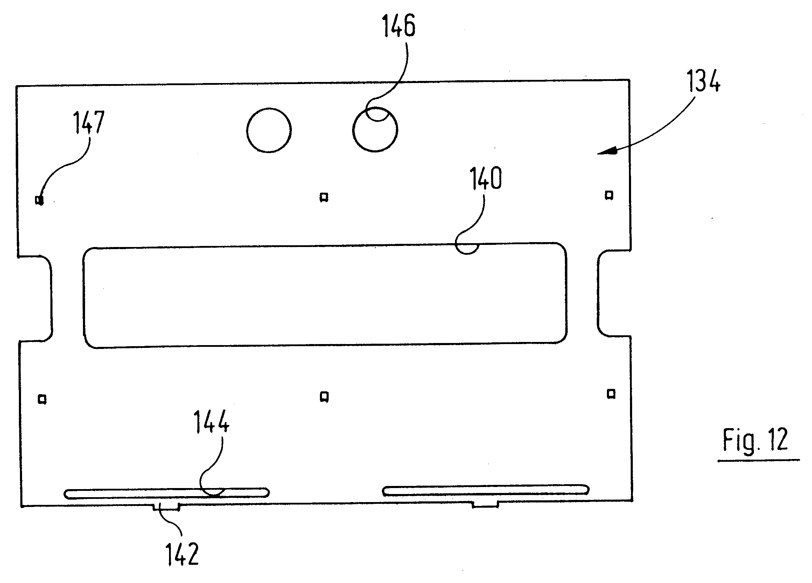

Wie aus Figur 12 ersichtlich, hat die Informationsplatine 134 ihrerseits ein mittiges Fenster 140, durch welches die Oberseite der Programmsteuerung 42 sichtbar ist, an welcher Leuchtdioden 141 vorgesehen sind, an denen der Arbeitszustand der Programmsteuerung ablesbar ist.

Beim in Figur 12 untenliegenden Längsrand der Informationsplatine 134 sind Rastnasen 142 vorgesehen, hinter denen Schlitze 144 liegen. Im gegenüberliegenden Abschnitt der Informationsplatine 134 sind zwei Greiflöcher 146 vorgesehen, an welchen man die Informationsplatine 134 unter elastischer Verformung der die Rastnasen 142 tragenden Stege aus dem oberen Gehäuseteil 12 herausziehen kann.

Auf der Oberseite der Informationsplatine vorgesehene Höcker 147 sorgen dafür, daß der mittlere Abschnitt der Informationsplatine vom Fenster 136 gemäß der Lage der Tragnuten 122 beabstandet sind.

Die Informationsplatine 134 ist aus opakem Material gefertigt und deckt so den Verkabelungsbereich im Gehäuseinneren ab, wobei auf die Oberseite der Informationsplatine 134 zusätzlich noch technische Informationen über die Verkabelung, den Steuerungstyp usw. aufgedruckt sein können.

Wie aus Figur 9 ersichtlich, trägt die Lochplatte 22 einen umlaufenden Dichtrahmen 148 mit kreisförmigem Querschnitt. Der Querschnittsdurchmesser entspricht dem Durchmesser der Nuten 24 und 26. Damit kann der mit 28 bezeichnete Randabschnitt des Dichtrahmens 148 unter radialer Kompression in die Nut 24 eingeführt werden, wodurch die Lochplatte 22 bleibend gelenkig mit dem unteren Gehäuseteil 10 verbunden wird. Damit kann man die Lochplatte 22 bei abgehobenem oder angehobenem oberen Gehäuseteil 12 zwischen einer in Figur 9 gestrichelt angedeuteten servicestellung und einer in Figur 9 durch ausgezogene Linien wiedergegebenen Arbeitsstellung verschwenken.

Für ein einfaches Aufsetzen des oberen Gehäuseteiles 12 sind dort die radial wieder nach innen springenden äußeren Endabschnitte der Seitenwände der Nut 26 abgefräst, so daß diese einen exakt halbkreisförmigen Nutgrund, sich hieran anschließende parallele Wandabschnitte und sich hieran anschließende Einführschrägen aufweist.

Wie aus Figur 10 ersichtlich, sind die Seitenteile 102 des unteren Gehäuseteiles 10 aus einem unsymmetrischen extrudierten Aluminium-Profilmaterial hergestellt, welches eine vertikale Wand 150, einen oberen horizontalen Schließflansch 152 sowie einen demgegenüber längeren unteren horizontalen Befestigungsflansch 154 aufweist. Derartige Profile sind als Standardprofile im Handel erhältlich.

Die Seitenteile 104 für das obere Gehäuseteil 12 sind aus einem extrudierten Profilmaterial aus Aluminium hergestellt welches eine vertikale Wand 156 und einen an deren unteres Ende angeformten Schließflansch 158 aufweist. Auch derartiges Profilmaterial ist ein im Handel erhältliches Standardprodukt, so daß man zum Aufbau der beiden Gehäuseteile 10, 12 nur ein gehäusespezifisches Profilmaterial aus Aluminium benötigt, aus welchem die Grundteile 98, 100 hergestellt werden, wobei das Grundteil 98 gar nicht und das Grundteil 100 nur geringfügig mechanisch zu bearbeiten ist.

Zwischen den gleiche Breite aufweisenden Schließflanschen 152 und 158 ist jeweils ein Dichtstreifen 160 angeordnet, der aus ölbeständigem Moosgummi hergestellt ist und die im einzelnen aus Figur 11 ersichtliche Geometrie hat.

An der bei eingebautem Dichtstreifen zum Gehäuseinneren weisenden Längskante sind in denjenigen Bereichen, in welchen der Dichtstreifen 160 vertikale Abschnitte 162 des Dichtrahmens 148 kreuzt, nach innen vorspringende Dichtstreifenabschnitte 164 mit gewölbtem Rand vorgesehen. Auf diese Weise erhält man im Überkreuzungsbereich der beiden Dichtungen, in welchem der Dichtrahmen 148 nicht gegen Metall gedrückt ist, einen zuverlässige Abdichtung.

In den Dichtstreifen 160 sind ferner U-förmige Ausnehmungen 166 vorgesehen, durch welche sich bei zusammengebautem Gehäuse Distanzringe 168 erstrecken, wie in Figur 10 gezeigt. Diese Ringe begrenzen die Kompression der Dichtstreifen 160 in Schließrichtung des Gehäuses, wenn die Schrauben 14 angezogen werden, die durch die Distanzringe 168 hindurchgesteckt sind.

Wie aus Figur 9 ersichtlich sind die Seitenteile mit Sackbohrungen 170 versehen, die mit Rastkugeln 172 zusammenarebiten, die in Rastgehäusen 174 in zur Zeicheneben senkrechter Richtung bewegbar geführt sind und durch nicht gezeigte Federn auf das benachbarte Seitenteil zu vorgespannt sind. Die Rastgehäuse 174 sind bei den seitlichen Rändern der Lochplatten vorgesehen.

Auf diese Weise bleiben die Lochplatten 22 nach dem Abnehmen des oberen Gehäuseteiles 12 auch dann in der in der Ebene des Fensters 20 liegenden Arbeitsstellung, wenn die durch sie durchgeführten Kabel unter Zug- oder Druckbelastung stehen. Sie können aber unter Anwendung einer Kraft, durch welche die Rastkugeln 172 aus den Sackbohrungen 170 freikommen, verschwenkt werden, um guten Zugang zu den Kabelenden und den Anschlußplatinen 124 zu gewähren.

## Patentansprüche

1. Gehäuse für eine Steuereinheit mit zwei dicht verbindbaren Gehäuseteilen (10 12) und einer Vielzahl von Kabel-Durchführöffnungen (32), dadurch gekennzeichnet, daß die Durchführöffnungen (32) in einer Lochplatte (22) ausgebildet sind, daß die beiden Gehäuseteile (10, 12) zusammen ein Fenster (20) begrenzen, in welches die zumindest am Rand elastisch verformbare Lochplatte (22) dicht einsetzbar ist; und daß die Lochplatte (22) bei jeder der Durchführöffnungen (32) elastische Dichtmittel umfaßt.

2. Gehäuse nach Anspruch 1, dadurch gekennzeichnet, daß die Durchführöffnungen (32) der Lochplatte (22) in gegeneinander versetzten Reihen angeordnet sind.

3. Gehäuse nach Anspruch 1 oder 2, dadurch gekennzeichnet, daß die senkrecht zur Gehäuse-Schließrichtung verlaufenden Randflächen des Fensters (20) Nuten (24, 26) aufweisen, in welchen die ihnen zugeordneten Randabschnitte (28, 30) der Lochplatte (22) formschlüssig einsitzen.

4. Gehäuse nach einem der Ansprüche 1-3, dadurch gekennzeichnet, daß die Lochplatte (22) insgesamt aus elastisch verformbarem Material hergestellt ist.

5. Gehäuse nach Anspruch 4, dadurch gekennzeichnet, daß die Lochplatte (22) zwei aus einem harten elastischen Material gefertigte unter Spiel kammartig ineinandergreifende Klemmkörper (64) aufweist, zwischen welchen sich demgegenüber weiches Material (68) erstreckt, in welchem die Durchführöffnungen (32) liegen.

6. Gehäuse nach Anspruch 5, dadurch gekennzeichnet, daß sich die Zinken (66) der Klemmkörper (64) zur Spitze hin verjüngen.

7. Gehäuse nach einem der Ansprüche 4-6, dadurch gekennzeichnet, daß ein Randabschnitt (28) der Lochplatte (22) schwalbenschwanzähnlich in der zugeordneten Nut (24) des einen Gehäuseteiles (10) einsitzt, während die Nut (26) des anderen Gehäuseteiles (12) und der in diese einführbare Randabschnitt (30) der Lochplatte (22) hinterschneidungsfrei ausgebildet sind, wobei der Querschnitt dieser Nut und des zugeordneten Randabschnittes vorzugsweise die Form eines gleichschenkligen Dreiecks hat.

8. Gehäuse nach einem der Ansprüche 4-7, dadurch gekennzeichnet, daß die Durchführöffnungen (32) durch einen angeformten Film (34) verschlossen sind.

9. Gehäuse nach einem der Ansprüche 1-3, dadurch gekennzeichnet, daß bei den Durchführöffnungen (32) jeweils eine Lippendichtung (86) vorgesehen ist, die vorzugsweise zumindest nach eingeführten Kabel (38) in den das Kabel umgebenden Abschnitt kegelstumpfförmig(88) ist.

10. Gehäuse nach Anspruch 9, dadurch gekennzeichnet, daß die Lippendichtungen (86) jeweils in ein ebenfalls kegelstumpfförmiges Zugentlastungsteil (72) eingeknöpft sind, welches mit der Durchführöffnung (32) verrastet ist und am inneren Ende durch Schlitze (74) getrennte Klemmarme (76) aufweist.

11. Gehäuse nach Anspruch 10, dadurch gekennzeichnet, daß der Einknöpfabschnitt (84) einer Lippendichtung (86) jeweils zwischen einen Stützwulst (82) des zugeordneten Zugentlastungsteiles (72) und die Außenfläche der Lochplatte (22) unter Zusammendrücken eingespannt ist.

12. Gehäuse nach einem der Ansprüche 1-11, dadurch gekennzeichnet, daß die Lippendichtung durch die Bodenwand (92) eines insgesamt im wesentlichen becherförmigen Dichtkörpers (86) gebildet ist.

13. Gehäuse nach Anspruch 12 in Verbindung mit Anspruch 13, dadurch gekennzeichnet, daß das Zugentlastungsteil (72) mehrere in Umfangsrichtung verteilte radial nach innen ragende Positionierrippen (96) aufweist.

14. Gehäuse nach einem der Ansprüche 9-13, dadurch gekennzeichnet, daß die Lochplatte (22) durch einen starren Plattenkörper und einen auf deren Rand aufgesetzten umlaufenden elastischen Dichtrahmen (148) gebildet ist, wobei Randabschnitte (28 30) des Dichtrahmens (148) und in den Randflächen des Fensters (20) vorgesehenen Nuten (24, 26) zueinander komplementäre Geometrie haben.

15. Gehäuse nach Anspruch 14, dadurch gekennzeichnet, daß der Dichtrahmen (148) kreisförmigen transversalen Querschnitt aufweist und der Grund der Nuten (24, 26) im wesentlichen halbkreisförmigen Querschnitt hat.

16. Gehäuse nach Anspruch 15, dadurch gekennzeichnet, daß der transversale Querschnitt der Nut (24) zumindest eines der Gehäuseteile (10 12) über einen Winkel von mehr als 180^{o}, vorzugsweise etwa 225^{o} kreisförmig ist.

17. Gehäuse nach Anspruch 16, dadurch gekennzeichnet, daß die Nuten (24, 26) mit Einführschrägen (114) versehen sind, die vorzugsweise unter einem Winkel von etwa 30^{o} zur Nutmittelebene geneigt verlaufen.

18. Gehäuse nach einem der Ansprüche 1-17, dadurch gekennzeichnet, daß es aus zwei Gehäuseteilen (10, 12) besteht, die ausgehend von einem gleichen Profilmaterial hergestellte Grundteile (98, 114) und Schließflansche (152, 158) aufweisende Seitenteile (102, 104) haben, wobei letztere durch Ablängen entsprechender Stücke von Winkelprofilmaterialien hergestellt sind, die in mindestens einer der Schenkellängen übereinstimmen.

19. Gehäuse nach Anspruch 18, dadurch gekennzeichnet, daß das Winkelprofilmaterial für die Seitenteile (102) eines (10) der Gehäuseteile (10, 12) einen Befestigungsflansch (154) aufweist, der am vom Schließflansch (152) abgelegenen Ende der Hauptwand (150) des Profilmateriales angeformt ist.

20. Gehäuse nach Anspruch 19, dadurch gekennzeichnet, daß die Innenfläche von hochgezogenen Randwänden (110, 112) des Grundteil-Profilmateriales mit in Längsrichtung verlaufenden Tragnuten (120, 122) versehen ist, in welche jeweils ein plattenförmiges Einsatzteil (124; 134) eingreifen kann.

21. Gehäuse nach Anspruch 20, dadurch gekennzeichnet, daß ein plattenförmiges Einsatzteil (124) des unteren Gehäuseteiles (10) Anschlußklemmen (132) trägt, am von der Nut (120) abliegenden Plattenrand über Distanzkörper (126) auf dem Boden des unteren Gehäuseteiles (10) aufruht und über eine lösbare Rastverbindung (128) in dieser Arbeitsstellung gehalten ist.

22. Gehäuse nach Anspruch 20 oder 21, dadurch gekennzeichnet, daß die Bodenwand des oberen Gehäuseteiles (12) ein Fenster (136) aufweist, daß in zwei einander gegenüberliegende Tragnuten (122) des oberen Gehäuseteiles (12) eine opake Platine (134) eingesetzt ist, die ihrerseits mindestens ein Fenster (140) aufweist, durch welche die Oberseite einer in das Gehäuse eingesetzten Programmsteuerung (42) sichtbar ist, und daß die opake Platine (134) mit Rastnasen (142) versehen ist, hinter denen vorzugsweise jeweils ein Schlitz (144) im Plattenmaterial ausgeschnitten ist, wobei in einem den Rastnasen (142) gegenüberliegenden Teil der Platine (134) vorzugsweise mindestens ein Greifloch (146) vorgesehen ist.

23. Gehäuse nach einem der Ansprüche 18-22, dadurch gekennzeichnet, daß zwischen den Paaren von Schließflanschen (152, 158) von oberem Gehäuseteil (12) und unterem Gehäuseteil (10) jeweils Dichtstreifen (160) angeordnet sind, welche in demjenigen Bereich, in welchem sie den Dichtrahmen (148) überkreuzen, mit einem zum Gehäuseinneren hin vorspringenden Dichtstreifenabschnitt (164) versehen sind.

24. Gehäuse nach Anspruch 23, dadurch gekennzeichnet, daß die Dichtstreifen (160) mit Ausnehmungen (166) versehen sind, innerhalb derer die Kompression der Dichtstreifen (160) beim Verschrauben der Gehäuseteile (10, 12) begrenzende Abstandselemente (168) angeordnet sind.

25. Gehäuse nach einem der Ansprüche 1-24, dadurch gekennzeichnet, daß für die Lochplatten (22) eine Einrichtung (170-174) zum lösbaren Verriegeln in ihrer in der Ebene des Fensters (14) liegenden Arbeitsstellung vorgesehen ist, insbesondere eine Rasteinrichtung.
